# EUROPEAN PATENT APPLICATION

(11) **EP 4 447 105 A1**
(43) Date of publication of application: **16.10.2024**
(21) Application number: 22923291.3
(22) Date of filing: 05.09.2022
(51) Int. Cl.: H01L 23/373, H01L 23/367, H01L 23/42, H01L 25/18, H01L 23/498, H01L 23/433, H01L 23/28

(54) **PACKAGING MODULE AND PREPARATION METHOD THEREFOR, AND ELECTRONIC DEVICE**

(30) Priority: 27.01.2022 CN 202210102826
(71) Applicant: Huawei Digital Power Technologies Co., Ltd., Shenzhen, Guangdong 518043 (CN)
(72) Inventor: KANG, Chen, Shenzhen, Guangdong 518043 (CN); LIAO, Xiaojing, Shenzhen, Guangdong 518043 (CN); LI, Jiwei, Shenzhen, Guangdong 518043 (CN)
(74) Representative: Isarpatent
(86) International application number: PCT/CN2022/117099
(87) International publication number: WO 2023/142487

(57) **Abstract**

This application provides a packaging module, including a circuit substrate, a first heat dissipation apparatus, and a second heat dissipation apparatus. The circuit substrate includes a first line layer, a first packaging layer, and a second line layer that are sequentially stacked. The first line layer is electrically connected to a first electronic component. The second line layer includes a heat dissipation region and an edge region that is connected to the heat dissipation region. The first electronic component is further electrically connected to the heat dissipation region. The edge region is electrically connected to a lead terminal. The first packaging layer packages the first electronic component and the first line layer. The first heat dissipation apparatus is located on a surface of the first line layer. The second heat dissipation apparatus is located on a surface of the heat dissipation region. This application further provides a method for preparing the packaging module and an electronic device using the packaging module. According to the packaging module in this application, the first line layer and the second line layer are designed in a way that heat dissipation apparatuses can be mounted on both a front surface and a back surface of the first electronic component, to implement double-sided heat dissipation, thereby improving heat dissipation efficiency.

## Description

### CROSS-REFERENCE TO RELATED APPLICATIONS

This application claims priority to Chinese Patent Application No. 202210102826.3, filed with the China National Intellectual Property Administration on January 27, 2022 and entitled "PACKAGING MODULE, METHOD FOR PREPARING SAME, AND ELECTRONIC DEVICE", which is incorporated herein by reference in its entirety.

### TECHNICAL FIELD

This application relates to a double-sided heat dissipation packaging module, a method for preparing the packaging module, and an electronic device using the packaging module.

### BACKGROUND

To adapt to an increasingly high power requirement, a power semiconductor device, especially a power-supply power semiconductor device, is increasingly evolving toward thinness, a small size, and high power density. Therefore, a heat dissipation requirement for the power semiconductor device is increasingly high.

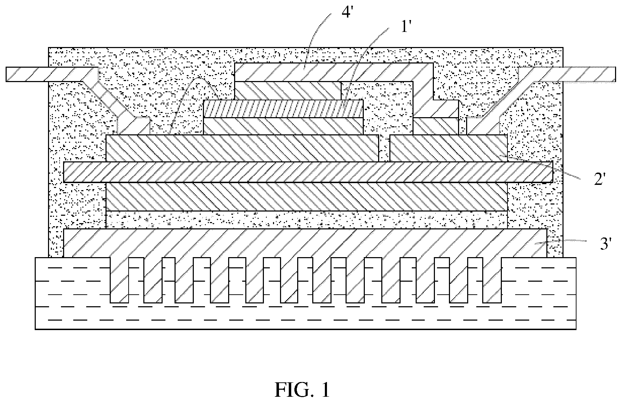

FIG. 1 shows an existing power semiconductor device. A back surface of a chip 1' is soldered to a circuit board 2'. A surface, away from the chip 1', of the circuit board 2' is connected to a heat sink 3. It is designed that pins are led out on a front surface of the chip 1'.

However, because the front surface of the chip 1' requires a bonding lead 4', a heat dissipation manner is difficult to design. Usually, only single-sided heat dissipation can be used, a heat dissipation capability is limited, and internal heat cannot be discharged in time. This may cause an excessively high temperature of the power semiconductor device, affect working efficiency and a service life of the power semiconductor device, and even cause an internal component to fail or burn.

### SUMMARY

A first aspect of this application provides a packaging module. The packaging module includes a circuit substrate, a first heat dissipation apparatus, and a second heat dissipation apparatus. The circuit substrate includes a first line layer, a first packaging layer, and a second line layer that are sequentially stacked. The first line layer is electrically connected to a first electronic component. The second line layer includes a heat dissipation region and an edge region that is connected to the heat dissipation region. The first electronic component is further electrically connected to the heat dissipation region. The edge region is electrically connected to a lead terminal. The first packaging layer packages the first electronic component and the first line layer. The first heat dissipation apparatus is located on a surface, away from the first electronic component, of the first line layer. The second heat dissipation apparatus is located on a surface, away from the first electronic component, of the heat dissipation region.

In this application, a non-working surface (that is, a back surface), on which no pin is disposed, of the first electronic component is mounted on the first line layer, and the first heat dissipation apparatus is mounted on the back surface of the first electronic component by using the first line layer. In addition, the second line layer including the heat dissipation region and the edge region is disposed on a working surface (that is, a front surface), on which pins are disposed, of the first electronic component. It is convenient to lead a side surface of the pins on the first electronic component out to the edge region of the second line layer to connect to the lead terminal. A mounting position is reserved on the heat dissipation region of the second line layer, to dispose the second heat dissipation apparatus on the front surface of the first electronic component. The packaging module in this application implements double-sided heat dissipation without affecting lead-out of the pins of the first electronic component. This improves heat dissipation efficiency of the packaging module and further improves working efficiency and increases a service life of the packaging module, helping the packaging module develop toward a direction of high density, thinness, and a small size.

With reference to the first aspect, in some embodiments, a first thermally conductive component is disposed between the first line layer and the first heat dissipation apparatus.

With reference to the first aspect, in some embodiments, a second thermally conductive component is disposed between the heat dissipation region and the second heat dissipation apparatus.

The first thermally conductive component and the second thermally conductive component are disposed, to accelerate heat dissipation in the circuit substrate and improve heat dissipation efficiency.

With reference to the first aspect, in some embodiments, the packaging module further includes a second packaging layer. The second packaging layer packages the first thermally conductive component, the circuit substrate, and the second thermally conductive component. A surface, away from the circuit substrate, of the first thermally conductive component and a surface, away from the circuit substrate, of the second thermally conductive component are exposed from the second packaging layer. The lead terminal extends out of the second packaging layer.

The second packaging layer is added, to improve connection stability between parts in the packaging module, and further improve reliability of the packaging module.

With reference to the first aspect, in some embodiments, the lead terminal extends out of a side wall of the second packaging layer.

The lead terminal is led out from the side wall of the second packaging layer, to provide a larger mounting area for the second heat dissipation apparatus, and improve heat dissipation efficiency.

With reference to the first aspect, in some embodiments, the second line layer includes a conducting wire and a first metal layer, two ends of the conducting wire are respectively electrically connected to the first electronic component and the lead terminal, and the first metal layer is located in the heat dissipation region and connected to the second heat dissipation apparatus.

The first metal layer with a large area is added in the heat dissipation region, to increase a contact area between the second line layer and the second thermally conductive component. This helps improve heat dissipation effect of the packaging module.

With reference to the first aspect, in some embodiments, a third thermally conductive component packaged in the first packaging layer is further disposed on the first line layer, and the third thermally conductive component is separately connected to the first line layer and the second line layer.

The third thermally conductive component is disposed in the first packaging layer, to effectively conduct heat gathered in the first packaging layer to the first line layer and the second line layer, and further improve efficiency of heat dissipation inside the packaging module.

With reference to the first aspect, in some embodiments, the second line layer is further electrically connected to a second electronic component.

The second electronic component is disposed on the second line layer, to increase space utilization inside the circuit substrate, and further increase packaging density of the packaging module.

With reference to the first aspect, in some embodiments, the first thermally conductive component includes a first insulative and thermally conductive layer and a second metal layer that are stacked, and the first insulative and thermally conductive layer is located between the first line layer and the second metal layer.

The first insulative and thermally conductive layer can implement insulation from the circuit substrate, and heat dissipation efficiency can be improved by introducing the second metal layer. In addition, the first insulative and thermally conductive layer can implement press-fit connection to the circuit substrate without introducing a soldering process, thereby simplifying a process.

With reference to the first aspect, in some embodiments, the second thermally conductive component includes a second insulative and thermally conductive layer and a third metal layer that are stacked, and the second insulative and thermally conductive layer is located between the second line layer and the third metal layer.

The second insulative and thermally conductive layer can implement insulation from the circuit substrate, and heat dissipation efficiency can be improved by introducing the third metal layer. In addition, the second insulative and thermally conductive layer can implement press-fit connection to the circuit substrate without introducing a soldering process, thereby simplifying a process.

With reference to the first aspect, in some embodiments, the second thermally conductive component includes a second insulative and thermally conductive layer and two third metal layers located on two opposite surfaces of the second insulative and thermally conductive layer. One of the third metal layers is connected to the second line layer through a connection layer, and the connection layer is made of a thermally conductive material.

The second thermally conductive component having the third metal layers on both surfaces is connected to the circuit substrate through a thermally conductive connection layer, to implement insulation and heat conduction. In addition, a plurality of the second thermally conductive components may be arranged based on a distribution status of heat sources inside the circuit substrate, and another electronic component may be introduced on the second line layer, to improve flexibility of structural design of the packaging module.

A second aspect of this application provides a method for preparing a packaging module. The preparation method includes the following steps:
providing a circuit substrate, where the circuit substrate includes a first line layer, a first packaging layer, and a second line layer that are sequentially stacked, the first line layer is electrically connected to a first electronic component, the second line layer includes a heat dissipation region and an edge region that is connected to the heat dissipation region, the first electronic component is further electrically connected to the heat dissipation region, the edge region is electrically connected to a lead terminal, and the first packaging layer packages the first electronic component and the first line layer;
disposing a first heat dissipation apparatus on a surface, away from the first electronic component, of the first line layer; and
disposing a second heat dissipation apparatus on a surface, away from the first electronic component, of the heat dissipation region, to obtain the packaging module.

According to the method for preparing a packaging module provided in this application, the first line layer is designed, to help mount the first heat dissipation apparatus on a back surface of the first electronic component. In addition, the second line layer including the heat dissipation region and the edge region is designed on a front surface of the first electronic component, pins of the first electronic component are led out to the edge region of the second line layer, and the heat dissipation region of the second line layer is reserved as a mounting position of the second heat dissipation apparatus. This achieves an objective of mounting the second heat dissipation apparatus on the front surface of the first electronic component, so that the packaging module implements double-sided heat dissipation without affecting mounting of the lead terminal, thereby effectively improving heat dissipation effect. The method for preparing a packaging module in this application has a simple process, is relatively easy to implement, has low costs, and facilitates mass production. In addition, a quantity of soldering times in an entire process is small, forming efficiency is high, and reliability of the packaging module is relatively high.

With reference to the second aspect, in some embodiments, a first thermally conductive component is disposed between the first line layer and the first heat dissipation apparatus. A method for preparing the circuit substrate includes the following steps:
forming the first line layer on a surface of the first thermally conductive component;
electrically connecting the first electronic component on a surface of the first line layer;
forming the first packaging layer on the surface of the first thermally conductive component, so that the first packaging layer packages the first electronic component and the first line layer;
forming the second line layer on a surface, away from the first thermally conductive component, of the first packaging layer, and electrically connecting the second line layer and the first electronic component; and
disposing the lead terminal on the edge region of the second line layer, so that the lead terminal is electrically connected to the second line layer, to form the circuit substrate on the surface of the first thermally conductive component.

With reference to the second aspect, in some embodiments, after the circuit substrate is formed on the surface of the first thermally conductive component, the method for preparing a packaging module further includes the following step:
disposing a second thermally conductive component on the heat dissipation region of the second line layer.

The circuit substrate is directly formed on the surface of the first thermally conductive component and the second thermally conductive component is mounted, so that a structure including the circuit substrate, the first thermally conductive component, and the second thermally conductive component may be formed in one step. A forming method is simple, easy to implement, and facilitates mass production. In addition, a quantity of soldering times in an entire process is small, forming efficiency is high, and reliability of the packaging module is relatively high.

With reference to the second aspect, in some embodiments, a first thermally conductive component is disposed between the first line layer and the first heat dissipation apparatus, a second thermally conductive component is disposed between the heat dissipation region and the second heat dissipation apparatus, and after the circuit substrate is obtained, the method for preparing a packaging module further includes the following step:
sequentially stacking and press-fitting the first thermally conductive component, the circuit substrate, and the second thermally conductive component.

The circuit substrate is first formed, and then the first thermally conductive component and the second thermally conductive component are press-fitted to the circuit substrate to form an entirety. The circuit substrate is separately formed, and then the circuit substrate having the first thermally conductive component and the second thermally conductive component is formed through press-fitting. A forming method is simple. This further simplifies a forming process, reduces forming difficulty of the packaging module, improves universality of the circuit substrate, improves forming efficiency, and further reduces a quantity of soldering times, improves reliability of the packaging module, and increases a product yield.

With reference to the second aspect, in some embodiments, a method for preparing the circuit substrate includes the following steps:
forming a second copper layer on a surface of a stripping layer of a carrier board;
patterning the second copper layer to form the first line layer;
electrically connecting the first electronic component on a surface of the first line layer;
forming the first packaging layer on the surface of the stripping layer, so that the first packaging layer packages the first electronic component and the first line layer;
forming the second line layer on a surface, away from the stripping layer, of the first packaging layer, and electrically connecting the second line layer and the first line layer;
electrically connecting the lead terminal on the second line layer; and removing the carrier board to obtain the circuit substrate.

According to the foregoing process for preparing the circuit substrate, the first line layer can be embedded in the first packaging layer, to reduce a thickness of the circuit substrate. In addition, the process for preparing the circuit substrate is simple, forming efficiency is relatively high, a product yield is high, costs are relatively low, and mass production is easy to implement.

With reference to the second aspect, in some embodiments, before the forming the first packaging layer, the method for preparing the circuit substrate further includes the following step:
disposing a third thermally conductive component on the first line layer, and connecting the third thermally conductive component and the first line layer.

With reference to the second aspect, in some embodiments, after the forming the second line layer, the method for preparing a packaging module further includes the following step:
electrically connecting a second electronic component on the second line layer.

With reference to the second aspect, in some embodiments, the second line layer is formed by using a redistribution layer technology.

At the second line layer formed by using the redistribution layer technology, pins with a high density distributed on a surface of the first electronic component can be led out to the edge region of the second line layer, to facilitate connection to the lead terminal on the edge region, and implement lateral lead-out of the lead terminal. In addition, the heat dissipation region is reserved to mount the second heat dissipation apparatus, to implement double-sided heat dissipation of the first electronic component. In addition, the second line layer formed by using the redistribution layer technology is relatively thin. Compared with formation of the second line layer by using a conventional line forming method, this helps reduce a total thickness of the circuit substrate, thereby facilitating design of thinness and a small size of the packaging module.

With reference to the second aspect, in some embodiments, before the first heat dissipation apparatus and the second heat dissipation apparatus are disposed, the method for preparing a packaging module further includes the following step:
disposing a second packaging layer configured to package the first thermally conductive component, the circuit substrate, and the second thermally conductive component, where a surface, away from the circuit substrate, of the first thermally conductive component and a surface, away from the circuit substrate, of the second thermally conductive component are exposed from the second packaging layer, and the lead terminal extends out of the second packaging layer.

A third aspect of this application provides an electronic device. The electronic device includes a housing and the foregoing packaging module located in the housing.

### BRIEF DESCRIPTION OF DRAWINGS

FIG. 1 is a schematic diagram of a structure of a packaging module in a conventional technology;
FIG. 2 is a schematic diagram of a structure of a packaging module according to an embodiment of this application;
FIG. 3 is a schematic diagram of a structure of a circuit substrate, a first thermally conductive component, and a second thermally conductive component in FIG. 2;
FIG. 4 is a top view of a second line layer in a packaging module according to an embodiment of this application;
FIG. 5 is a schematic diagram of a structure of a connection pad in a packaging module according to an embodiment of this application;
FIG. 6 is a schematic diagram of a structure of a packaging module according to another embodiment of this application;
FIG. 7 is a schematic diagram of a structure of a packaging module according to still another embodiment of this application;
FIG. 8A is a flowchart of a method for preparing a packaging module according to an embodiment of this application;
FIG. 8B is a flowchart of a method for preparing a circuit substrate according to an embodiment of this application;
FIG. 8C is a flowchart of a method for preparing a packaging module according to another embodiment of this application;
FIG. 8D is a flowchart of a method for preparing a circuit substrate according to another embodiment of this application;
FIG. 9A is a schematic diagram 1 of a process of preparing a packaging module according to an embodiment of this application;
FIG. 9B is a schematic diagram 2 of a process of preparing a packaging module according to an embodiment of this application;
FIG. 9C is a schematic diagram 3 of a process of preparing a packaging module according to an embodiment of this application;
FIG. 9D is a schematic diagram 4 of a process of preparing a packaging module according to an embodiment of this application;
FIG. 9E is a schematic diagram 5 of a process of preparing a packaging module according to an embodiment of this application;
FIG. 9F is a schematic diagram 6 of a process of preparing a packaging module according to an embodiment of this application;
FIG. 9G is a schematic diagram 7 of a process of preparing a packaging module according to an embodiment of this application;
FIG. 10 is a schematic diagram of a process of preparing a packaging module according to another embodiment of this application;
FIG. 11A is a schematic diagram 1 of a process of preparing a circuit substrate according to another embodiment of this application;
FIG. 11B is a schematic diagram 2 of a process of preparing a circuit substrate according to another embodiment of this application;
FIG. 11C is a schematic diagram 3 of a process of preparing a circuit substrate according to another embodiment of this application;
FIG. 11D is a schematic diagram 4 of a process of preparing a circuit substrate according to another embodiment of this application; and
FIG. 12 is a schematic diagram of a structure of an electronic device according to an embodiment of this application.

### DESCRIPTION OF EMBODIMENTS

The following describes embodiments of this application with reference to accompanying drawings in embodiments of this application.

A common power semiconductor device usually uses single-sided heat dissipation. A heat dissipation apparatus is disposed on a back surface of a chip, and a lead needs to be designed on a front surface of the chip. Therefore, double-sided heat dissipation is difficult to implement, and heat dissipation efficiency is low.

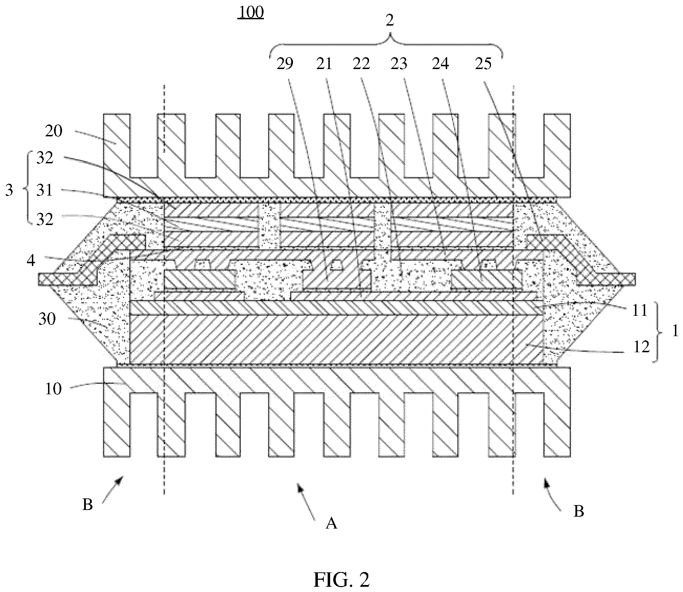

In view of this, with reference to FIG. 2, to improve heat dissipation efficiency of a power semiconductor device, this application provides a packaging module 100 that can implement double-sided heat dissipation. The packaging module 100 may be a power semiconductor device, configured to perform power processing, including frequency conversion, voltage conversion, current conversion, power management, and the like.

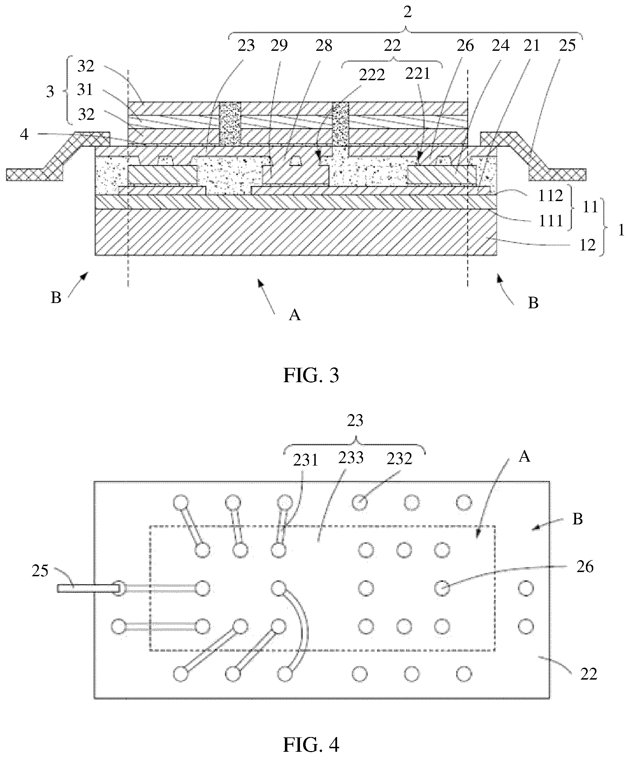

As shown in FIG. 2 and FIG. 3, the packaging module 100 includes a circuit substrate 2, a first heat dissipation apparatus 10, and a second heat dissipation apparatus 20. The circuit substrate 2 includes a first line layer 21, a first packaging layer 22, and a second line layer 23 that are sequentially stacked. The first line layer 21 is electrically connected to a first electronic component 24. The second line layer 23 includes a heat dissipation region A and an edge region B that is connected to the heat dissipation region A. The first electronic component 24 is further electrically connected to the heat dissipation region A. The edge region B is electrically connected to a lead terminal 25. The first packaging layer 22 packages the first electronic component 24 and the first line layer 21. The first heat dissipation apparatus 10 is located on a surface, away from the first electronic component 24, of the first line layer 21. The second heat dissipation apparatus 20 is located on a surface, away from the first electronic component 24, of the heat dissipation region A.

As shown in FIG. 2 and FIG. 3, the first line layer 21 of the circuit substrate 2 is embedded in the first packaging layer 22. This helps reduce a thickness of the circuit substrate 2.

The first electronic component 24 may include one or more active devices, for example, an active chip, including but not limited to a power supply chip, a digital chip, a radio frequency chip, and the like. In this embodiment, the first electronic component 24 may include a power chip like an insulated gate bipolar transistor (Insulated Gate Bipolar Transistor, IGBT), a silicon carbide (SiC), and a gallium nitride (GaN). It may be understood that the first electronic component 24 may further include one or more passive devices, including but not limited to a resistor, a capacitor, an inductor, a filter, a coupler, and the like. A back surface (that is, a non-acting surface) of the first electronic component 24 may be disposed on the first line layer 21 by using a mounting method, and specifically, may be mounted on a surface of the first line layer 21 in a flip chip manner.

The first packaging layer 22 is made of an insulative and thermally conductive packaging material, usually including an insulative resin and an insulative and thermally conductive filler. The insulative resin may be selected from one of resins such as an ABF resin, a prepreg (Prepreg, PP), an epoxy resin (epoxy resin), a BT resin, a polyphenylene oxide (Polyphenylene Oxide, PPO), a polyimide (polyimide, PI), a polyethylene terephthalate (Polyethylene Terephthalate, PET), and a polyethylene naphthalate (Polyethylene Naphthalate, PEN). Specifically, in this embodiment, the insulative resin used for the first packaging layer 22 may be an ABF resin. The ABF resin helps manufacture a thin line, and is applicable to packaging of a chip with a large quantity of pins and high-speed transmission. The insulative and thermally conductive filler may be selected from particles such as nano silicon oxide powder, nano silicon nitride powder, nano silicon carbide powder, nano boron nitride powder, and nano aluminum oxide powder. For example, the insulative and thermally conductive packaging material may be obtained by evenly dispersing the ABF resin and the insulative and thermally conductive filler. The first packaging layer 22 made of the insulative and thermally conductive ABF resin has characteristics such as a high coefficient of heat conductivity, high dielectric performance, a low coefficient of thermal expansion, high strength, high hardness, and non-poisonousness and harmlessness, and is applicable to packaging of precision electronic parts.

As shown in FIG. 3, a first through hole 221 is formed at the first packaging layer 22, and a conductor 26 is formed in the first through hole 221, to implement electrical connection between the second line layer 23 and the first electronic component 24, and further lead out pins on the first electronic component 24. The first through hole 221 is formed by laser drilling or mechanical drilling. A shape of the first through hole 221 is not limited, and may be a circle or another shape, for example, a rectangle, a triangle, or another irregular shape. The first through hole 221 that runs through the first packaging layer 22 above the first electronic component 24 is formed in a conventional drilling manner. The drilling manner is simple and easy to implement, and costs are low. In addition, the first packaging layer 22 is made of an ABF packaging material. This facilitates laser-structuring of the first through hole 221 with a smaller size, to adapt to pin lead-out of the first electronic component 24 with a large quantity of pins and high-speed transmission.

The conductor 26 is formed by electroplating copper in the first through hole 221, and the conductor 26 is formed in an electroplating manner. This can improve connection stability between the conductor 26 and the first electronic component 24, the process is simple and is easy to implement, and costs are low. In addition, the conductor 26 may be arranged based on an actual pin position of the first electronic component 24 in an electroplating manner, and a structure form of the conductor 26 may be designed as required, so that a limitation is small. In another embodiment, the conductor 26 may alternatively be formed by filling the first through hole 221 with a conductive paste and curing the conductive paste. The conductor 26 is formed by filling the conductive paste and curing the conductive paste. The process is simple, the operation is easy, and costs are low. In addition, a part of the first packaging layer 22 is removed in a polishing manner, so that an end, away from the first electronic component 24, of the conductor 26 is fully exposed from a surface, away from the first insulative and thermally conductive layer 11, of the first packaging layer 22, facilitating subsequent line lead-out to form the second line layer 23.

As shown in FIG. 3 and FIG. 4, the heat dissipation region A of the second line layer 23 is approximately located in the middle of the second line layer 23, and the edge region B is located on an outer side of the heat dissipation region A. The first through hole 221 and the conductor 26 are distributed on a front surface of the first electronic component 24, that is, located in the heat dissipation region A. The second line layer 23 is a redistribution layer formed by using a redistribution layer (Redistribution Layer, RDL) technology. A spacing between the conductors 26 with a relatively high distribution density may be enlarged by using the RDL technology, and conductors 26 corresponding to the heat dissipation region A are led out to the edge region B. This helps solder the lead terminal 25 in the edge region B and dispose the second heat dissipation apparatus 20 in the heat dissipation region A. Specifically, the second line layer 23 includes a conducting wire 231, a connection pad 232, and a first metal layer 233. The connection pad 232 is distributed in the edge region B, one end of the conducting wire 231 is electrically connected to the conductor 26 in the heat dissipation region A, and the other end of the conducting wire 231 extends from the heat dissipation region A to the edge region B, and is electrically connected to the connection pad 232 in the edge region B. The first metal layer 233 is located in the heat dissipation region A, and is not electrically connected to the conducting wire 231. The first metal layer 233 with a large area is added to provide a flat surface for connection of the second heat dissipation apparatus 20. In addition, the first metal layer 233 with a large area may further improve heat dissipation effect. According to the redistribution layer design of the second line layer 23, a plurality of the conductors 26 with a high density and vertically distributed in the heat dissipation region A are led out through the conducting wires 231 and a plurality of the connection pads 232 that are evenly distributed in the edge region B, to implement lead-out of pins on a plurality of the first electronic components 24, help solder the lead terminal 25 in the edge region B, and implement lateral lead-out of the lead terminal 25. In addition, the first metal layer 233 with a large area in the heat dissipation region A of the second line layer 23 is exposed, to help to connect the second heat dissipation apparatus 20, thereby achieving an objective of disposing the second heat dissipation apparatus 20 on the front surface of the first electronic component 24. In addition, the second line layer 23 formed by using the RDL technology is relatively thin. Compared with formation of the second line layer by using a conventional line forming method, this helps reduce a thickness of the circuit substrate 2, thereby facilitating design of thinness and a small size of the packaging module 100.

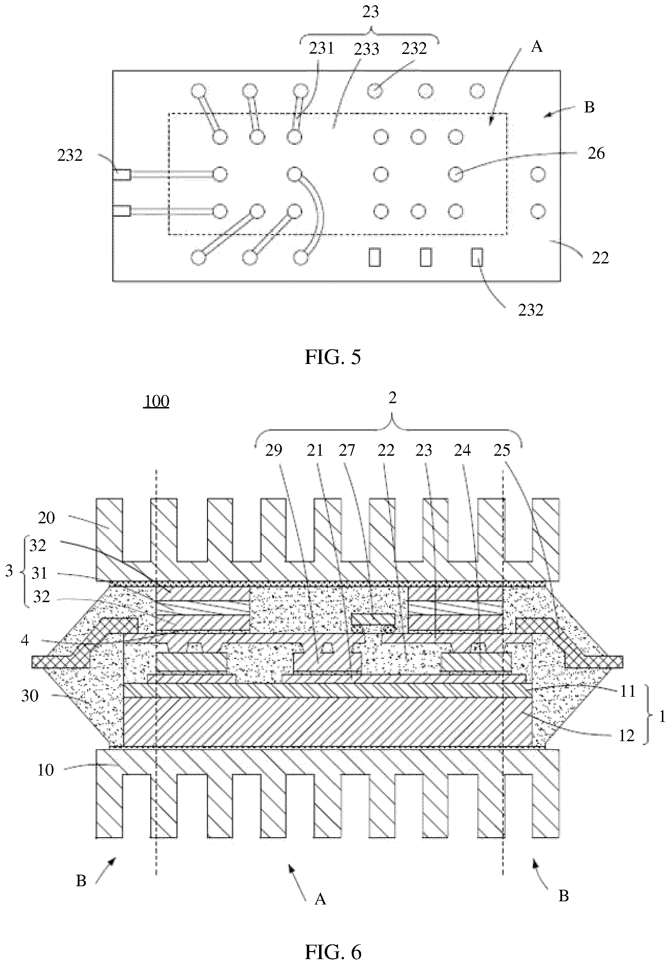

As shown in FIG. 3 and FIG. 4, a plurality of the connection pads 232 may be arranged based on an actual quantity of pins of the first electronic component 24 and specific positions of the pins actually connected to the lead terminal 25, and the plurality of the connection pads 232 may be arranged as an array and evenly distributed in the edge region B. A shape and a size of the connection pad 232 are not limited, and the shape may be a circle. As shown in FIG. 5, the shape may be another shape, for example, a rectangle, a triangle, a long strip with a length-to-diameter ratio, or another irregular shape. In this application, a position, a size, and a shape of the connection pad 232 may be properly arranged based on an actual quantity of the first electronic components 24, to reduce a layout area of the connection pad 232 and an area of the edge region B, thereby increasing an area of the heat dissipation region A, and improving heat dissipation efficiency of the packaging module 100.

A plurality of the connection pads 232 may be arranged evenly in a regular manner. As shown in FIG. 3, the plurality of the connection pads 232 may be arranged as an array. In another embodiment, the plurality of the connection pads 232 may alternatively be arranged unevenly or in an irregular manner. As shown in FIG. 4, shapes of the plurality of the connection pads 232 may be long strips with different length-to-diameter ratios, or may be circles. Such a design can help identify the pins of the first electronic component 24 that are led out, and prevent different pins from being incorrectly connected to the lead terminal 25.

As shown in FIG. 2 and FIG. 4, the connection pad 232 is electrically connected to the lead terminal 25 by using an anisotropic conductive adhesive, and the lead terminal 25 is electrically connected to the connection pad 232 by attaching the anisotropic conductive adhesive, to achieve high connection stability. When the lead terminal 25 is bent or shaken, reliability of the packaging module 100 is not reduced. In addition, attaching the anisotropic conductive adhesive is easy to operate, and can reduce a quantity of soldering times, improve efficiency, and reduce costs. Furthermore, a thickness of the anisotropic conductive adhesive is relatively thin, and does not occupy excessively large space. It may be understood that the connection pad 232 may alternatively be electrically connected to the lead terminal 25 in a soldering manner.

As shown in FIG. 2 and FIG. 3, a third thermally conductive component 29 is further disposed on the first line layer 21, the third thermally conductive component 29 is packaged in the first packaging layer 22, and two opposite surfaces of the third thermally conductive component 29 are respectively connected to the first line layer 21 and the second line layer 23. The third thermally conductive component 29 is added in the first packaging layer 22, so that heat accumulated in the first packaging layer 22 may be further quickly conducted to the first line layer 21 and the second line layer 23 through the third thermally conductive component 29, and the heat may be further conducted to the packaging module 100. Therefore, heat dissipation efficiency inside the first packaging layer 22 is improved. In this embodiment, a second through hole 222 is provided at the first packaging layer 22 above the corresponding third thermally conductive component 29, and a heat conductor 28 is disposed in the second through hole 222. The heat conductor 28 is in contact with the third thermally conductive component 29. In this embodiment, the third thermally conductive component 29 may be a metal block. When the first electronic component 24 is mounted, the third thermally conductive component 29 may be mounted on the surface of the first line layer 21. Specifically, the third thermally conductive component 29 may be fastened to the first line layer 21 by using a thermally conductive adhesive or soldering.

It may be understood that, as shown in FIG. 6, in another implementation, a second electronic component 27 may be further disposed on the second line layer 23. The second electronic component 27 may include one or more active devices, for example, an active chip, including but not limited to a drive chip, a power supply chip, a digital chip, a radio frequency chip, and the like. It may be understood that the second electronic component 27 may further include one or more passive devices, and the passive devices include but are not limited to a resistor, a capacitor, an inductor, a filter, a coupler, and the like. In this embodiment, the second electronic component 27 may be a gate-level drive chip, and is electrically connected to the first electronic component 24 through the second line layer 23, to achieve a purpose of driving the first electronic component 24.

As shown in FIG. 2 and FIG. 3, a first thermally conductive component 1 is disposed between the first line layer 21 and the first heat dissipation apparatus 10, to improve heat conduction efficiency between the circuit substrate 2 and the first heat dissipation apparatus 10. The first thermally conductive component 1 includes a first insulative and thermally conductive layer 11, and a second metal layer 12 located on a first surface 111 of the first insulative and thermally conductive layer 11. The first line layer 21 is located on a second surface 112 of the first insulative and thermally conductive layer 11. The second surface 112 is disposed opposite to the first surface 111. The first packaging layer 22 is located on the second surface 112.

The first insulative and thermally conductive layer 11 may be a resin or an insulative ceramic with high insulation and heat conduction, but is not limited thereto. The second metal layer 12 may be a metal layer. In this embodiment, the first thermally conductive component 1 may be a direct bonding copper (direct bonding copper, DBC), an active metal bonding (active metal bonding, AMB), or the like. Such first thermally conductive component 1 not only features higher heat conductivity, high bonding strength between a copper layer and a ceramic base layer (for example, silicon nitride ceramic), but also has a low coefficient of thermal expansion (especially, a coefficient of thermal expansion of the AMB direct bonding copper is similar to a coefficient of thermal expansion of silicon). Such first thermally conductive component 1 may be used in a high voltage operation without partial discharge. It may be understood that the metal layer may be thickened on a surface of a metal layer of the original direct bonding copper in a form of electroplating, to form the second metal layer 12, achieving ideal heat conduction effect.

The circuit substrate 2 is directly formed on the first surface 111 of the first insulative and thermally conductive layer 11, and the first line layer 21 and the first thermally conductive component 1 are of an integrated structure. In this embodiment, the first surface 111 and the second surface 112 that are of the first insulative and thermally conductive layer 11 are respectively coated with metal layers, that is, an integrated structure including the first line layer 21 and the first thermally conductive component 1 is prepared by using a double-sided copper clad laminate. A metal layer on the first surface 111 of the first insulative and thermally conductive layer 11 is used as the second metal layer 12, and a metal layer is disposed on the second surface 112 of the first insulative and thermally conductive layer 11, and the metal layer is patterned to prepare the first line layer 21. The first line layer 21 is in close contact with the first thermally conductive component 1 and has strong bonding force, and has relatively good thermally conductive effect. The first thermally conductive component 1 can quickly conduct heat in the first line layer 21 to the first heat dissipation apparatus 10. This helps improve heat dissipation efficiency on a back surface of the first electronic component 24.

As shown in FIG. 2 and FIG. 3, a second thermally conductive component 3 is disposed between the heat dissipation region A and the second heat dissipation apparatus 20. The second thermally conductive component 3 can improve heat conduction efficiency between the heat dissipation region A and the second heat dissipation apparatus 20. The second thermally conductive component 3 includes a second insulative and thermally conductive layer 31 and third metal layers 32 that are located on two opposite surfaces of the second insulative and thermally conductive layer 31. The second insulative and thermally conductive layer 31 may be made of a resin or an insulative ceramic with high insulation and heat conduction, or another material capable of simultaneously performing insulation and heat conduction functions. The third metal layer 32 is a copper layer. In this embodiment, the second thermally conductive component 3 may be a DBC board, an AMB board, or the like. The DBC board or the AMB board has relatively high heat conductivity, relatively high heat conductivity efficiency, and a low coefficient of thermal expansion (especially, a coefficient of thermal expansion of the AMB board is almost similar to a coefficient of thermal expansion of silicon), and may be used in a high voltage operation without partial discharge. The second thermally conductive component 3 may be connected to the heat dissipation region A through a connection layer 4. Specifically, the connection layer 4 may be formed by curing a thermally conductive resin, or may be formed by soft brazing or silver sintering. It may be understood that a quantity of the second thermally conductive components 3 may be one or more, and the quantity of the second thermally conductive components 3 may be set based on distribution of the first metal layer 233 and the conducting wire 231 in the heat dissipation region A. It may be further understood that, as shown in FIG. 5, in another embodiment, the quantity and mounting positions of the second thermally conductive components 3 may be set based on whether the second electronic component 27 needs to be mounted on the second line layer 23. The second thermally conductive component 3 having the third metal layers 32 on both surfaces is connected to the circuit substrate 2 through a thermally conductive connection layer 4, to implement insulation and heat conduction. In addition, a plurality of the second thermally conductive components 3 may be arranged based on a distribution status of heat sources inside the circuit substrate 2, and another electronic component (for example, the second electronic component 27) may be introduced on the second line layer 23. This improves flexibility of structural design of the packaging module 100.

As shown in FIG. 2, the packaging module 100 further includes a second packaging layer 30. The second packaging layer 30 packages the first thermally conductive component 1, the circuit substrate 2, and the second thermally conductive component 3. A surface, away from the second line layer 23, of the second thermally conductive component 3 and a surface, away from the first line layer 21, of the first thermally conductive component 1 are exposed from the second packaging layer 30, and the lead terminal 25 extends out of the second packaging layer 30. The second packaging layer 30 is added, so that connection stability between the circuit substrate 2, the first thermally conductive component 1, and the second thermally conductive component 3 can be improved, thereby improving reliability of the packaging module 100.

The second packaging layer 30 is made of an insulative and thermally conductive packaging material, and usually includes an insulative resin and an insulative and thermally conductive filler. The insulative resin may be selected from one of resins such as an ABF resin, a prepreg (Prepreg, PP), an epoxy resin (epoxy resin), a BT resin, a polyphenylene oxide (Polyphenylene Oxide, PPO), a polyimide (polyimide, PI), a polyethylene terephthalate (Polyethylene Terephthalate, PET), and a polyethylene naphthalate (Polyethylene Naphthalate, PEN). Specifically, in this embodiment, the insulative resin used for the first packaging layer 22 may be the epoxy resin, and the insulative and thermally conductive filler may be selected from particles such as nano silicon oxide powder, nano silicon nitride powder, nano silicon carbide powder, nano boron nitride powder, and nano aluminum oxide powder. For example, the insulative and thermally conductive packaging material may be obtained by evenly dispersing the epoxy resin and the insulative and thermally conductive filler. The epoxy resin is a modified epoxy resin obtained by processing the nano-silicon dioxide. The insulative and thermally conductive material is a modified silicon carbide powder obtained by processing a silane coupling agent. The second packaging layer 30 obtained by filling the insulative and thermally conductive material with the modified nano epoxy resin has characteristics such as a high coefficient of heat conductivity, high dielectric performance, a low coefficient of thermal expansion, high strength, high hardness, and non-poisonousness and harmlessness, and is applicable to packaging of precision electronic parts. It may be understood that another material having characteristics such as the high coefficient of heat conductivity, high dielectric performance, low coefficient of thermal expansion, high strength, high hardness, and non-poisonousness and harmlessness may also be applicable to the packaging module 100 provided in this application.

As shown in FIG. 2, the first heat dissipation apparatus 10 and the second heat dissipation apparatus 20 may be air-cooled radiators or water-cooled radiators, but are not limited thereto. The first heat dissipation apparatus 10 and the second heat dissipation apparatus 20 may be respectively connected to the first thermally conductive component 1 and the second thermally conductive component 3 through a thermally conductive adhesive layer (for example, thermally conductive silica gel) or a soldering layer. In this embodiment, due to existence of the second packaging layer 30, a surface, away from the second line layer 23, of the second thermally conductive component 3 is flush with a surface of the second packaging layer 30, to provide a flat functional surface for the thermally conductive adhesive layer or the soldering layer. This helps improve connection stability of the second heat dissipation apparatus 20 and also helps improve heat dissipation efficiency.

In the packaging module 100 provided in this embodiment of this application, the second line layer 23 is formed by using a redistribution layer technology on a working surface (that is, a front surface) on which pins are disposed on the first electronic component 24, so that the pins of the first electronic component 24 is easily led out to the edge region B of the second line layer 23, the lead terminal 25 is easily soldered, and space for the heat dissipation region A is reserved to mount the second thermally conductive component 3. Further, the second heat dissipation apparatus 20 can be disposed on the front surface of the first electronic component 24. The first line layer 21 is directly formed on the first thermally conductive component 1 having the second metal layer 12, a non-working surface (that is, a back surface), on which no pin is disposed, of the first electronic component 24 is mounted on the first line layer 21, and the first thermally conductive component 1 is disposed on the back surface of the first electronic component 24 through the first line layer 21, to connect to the first heat dissipation apparatus 10. The packaging module 100 in this application implements double-sided heat dissipation of the first electronic component 24 without affecting the lead-out of the pins of the first electronic component 24. This improves heat dissipation efficiency of the packaging module 100, thereby improving working efficiency and a service life of the packaging module 100, and helping the packaging module 100 develop toward high density, thinness, and a small size. The packaging module 100 provided in this application is not only applicable to a silicon-based high-power module, but also applicable to a third-generation semiconductor chip, and can effectively improve heat dissipation efficiency of a power module, thereby improving working efficiency and performance reliability of the power module.

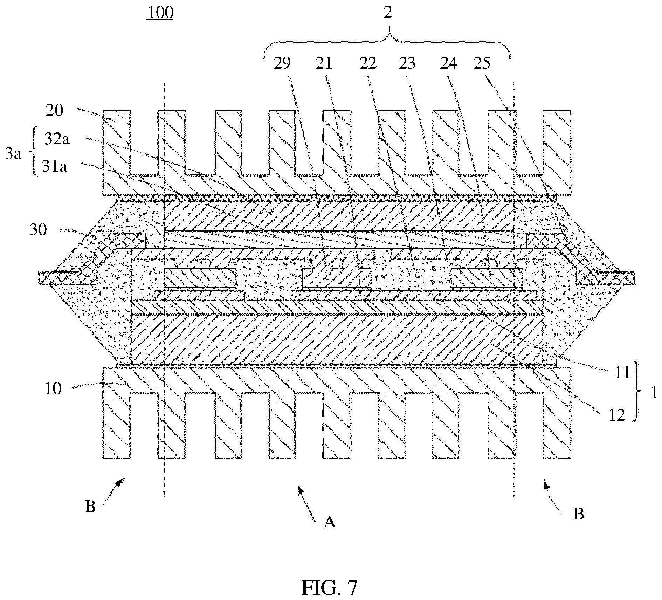

Refer to FIG. 7. A structure difference between a packaging module 200 in another embodiment of this application and the packaging module 100 in the foregoing embodiment lies in that: A second thermally conductive component 3a in the packaging module 200 in this embodiment includes a second insulative and thermally conductive layer 31a in contact with the second line layer 23, and a third metal layer 32a disposed on a surface, away from the second line layer 23, of the second insulative and thermally conductive layer 31a, a quantity of the second thermally conductive component 3a is one, and a heat dissipation region A of the second line layer 23 is covered by the second thermally conductive component 3a.

In this embodiment, the second thermally conductive component 3a is directly press-fitted on the surface of the second line layer 23, and does not need to be connected to the second line layer 23 by using a thermally conductive adhesive or soldering. The second thermally conductive component 3a may be a DBC board, an AMB board, or the like, and the third metal layer 32a may be thickened in an electroplating manner, to achieve optimal heat dissipation effect.

Compared with the foregoing embodiment, the second thermally conductive component 3a in the packaging module 200 in this embodiment can fully cover the heat dissipation region A without a gap. This increases a contact area between the second thermally conductive component 3a and the second line layer 23 and effectively improves heat dissipation efficiency. In addition, the second thermally conductive component 3a is directly press-fitted on the surface of the second line layer 23, without an intermediate connection layer. This simplifies a process, and increases bonding strength between the second thermally conductive component 3a and the second line layer 23, thereby improving stability of the packaging module 200, and helping reduce a thickness of the packaging module 200.

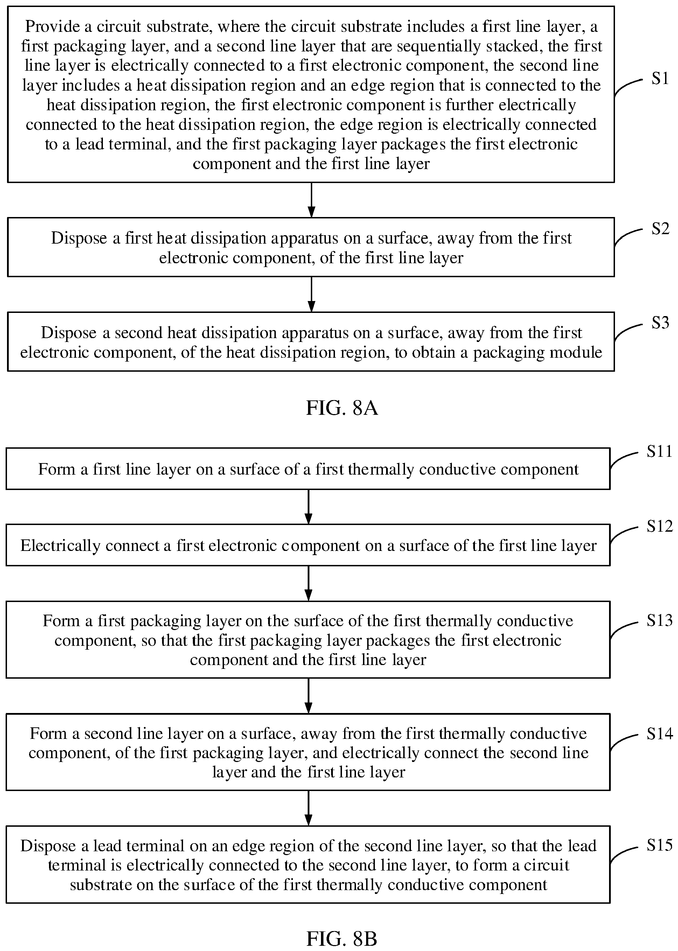

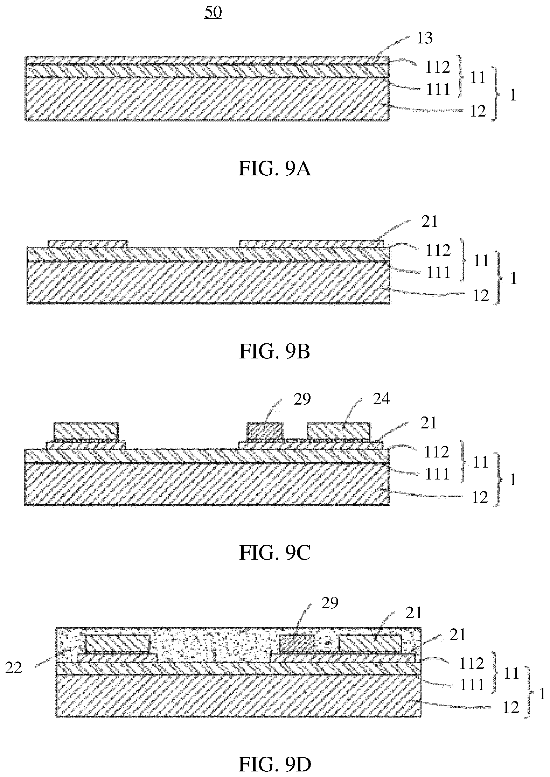

As shown in FIG. 8A, an embodiment of this application further provides a method for preparing the foregoing packaging module 100. The method includes the following steps (it is understood that the following steps may be performed with reference to FIG. 9A to FIG. 9G).

S1: Provide a circuit substrate 2, where the circuit substrate 2 includes a first line layer 21, a first packaging layer 22, and a second line layer 23 that are sequentially stacked, the first line layer 21 is electrically connected to a first electronic component 24, the second line layer 23 includes a heat dissipation region A and an edge region B that is connected to the heat dissipation region A, the first electronic component 24 is further electrically connected to the heat dissipation region A, the edge region B is electrically connected to a lead terminal 25, and the first packaging layer 22 packages the first electronic component 24 and the first line layer 21.

S2: Dispose a first heat dissipation apparatus 10 on a surface, away from the first electronic component 24, of the first line layer 21.

S3: Dispose a second heat dissipation apparatus 20 on a surface, away from the first electronic component 24, of the heat dissipation region A, to obtain the packaging module 100.

For step S1, refer to FIG. 8B. With reference to FIG. 9A to FIG. 9G, a first thermally conductive component 1 is disposed between the first line layer 21 and the first heat dissipation apparatus 10. A method for preparing the circuit substrate 2 includes the following steps.

S 11: As shown in FIG. 9A and FIG. 9B, form the first line layer 21 on a surface of the first thermally conductive component 1.

As shown in FIG. 9A, a double-sided substrate 50 is provided. The double-sided substrate 50 includes a first thermally conductive component 1 and a first copper layer 13. The first copper layer 13 is disposed on a second surface 112 of a first insulative and thermally conductive layer 11.

As shown in FIG. 9B, the first copper layer 13 is patterned to form the first line layer 21.

The first copper layer 13 is patterned by laminating, exposure and development, and etching, to form the first line layer 21.

S12: As shown in FIG. 9C, electrically connect the first electronic component 24 on a surface of the first line layer 21.

The first electronic component 24 is soldered at a corresponding position of the first line layer 21 in a flip chip manner.

When the first electronic component 24 is mounted on the first line layer 21, a third thermally conductive component 29 may also be disposed on the first line layer 21. In this embodiment, the third thermally conductive component 29 may be a metal block, and may be mounted on the first line layer 21 in a soldering manner.

S13: As shown in FIG. 9D, form the first packaging layer 22 on the surface of the first thermally conductive component 1, so that the first packaging layer 22 packages the first electronic component 24 and the first line layer 21.

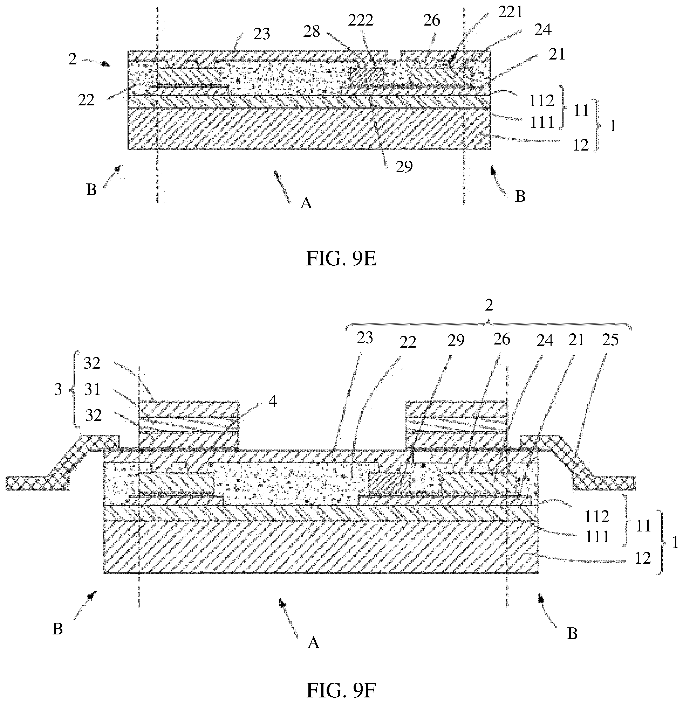

S14: As shown in FIG. 9E, form the second line layer 23 on a surface, away from the first thermally conductive component 1, of the first packaging layer 22, and electrically connect second line layer 23 and the first electronic component 24.

A first through hole 221 is formed at the first packaging layer 22 above the first electronic component 24, and a conductor 26 is formed in the first through hole 221. Pins on the first electronic component 24 are led out through the conductor 26, to implement electrical connection between the first electronic component 24 and the second line layer 23. The heat dissipation region A is approximately located in the middle of the second line layer 23. The edge region B is located on a side edge of the heat dissipation region A. The conductor 26 is disposed corresponding to the heat dissipation region A. The second line layer 23 includes a conducting wire 231, a connection pad 232, and a first metal layer 233. The connection pad 232 is distributed in the edge region B, one end of the conducting wire 231 is electrically connected to the conductor 26 in the heat dissipation region A, and the other end of the conducting wire 231 extends from the heat dissipation region A to the edge region B, and is electrically connected to the connection pad 232 in the edge region B. The first metal layer 233 is located in the heat dissipation region A and is not electrically connected to the conducting wire 231. It may be understood that, a second through hole 222 may be disposed at a position, corresponding to the third thermally conductive component 29, of the first packaging layer 22, and a heat conductor 28 is disposed in the second through hole 222, so that the heat conductor 28 is in contact with the third thermally conductive component 29, to dissipate heat inside the first packaging layer 22.

The second line layer 23 is a redistribution layer formed by using a redistribution layer technology. First, the first through hole 221 and the second through hole 222 are formed at the first packaging layer 22, then the conductor 26 and the heat conductor 28 are formed in the first through hole 221 and the second through hole 222 respectively in an electroplating manner, next, a copper layer is formed by electroplating on a surface, away from the first thermally conductive component 1, of the first packaging layer 22, and finally, the second line layer 23 is formed by using processes of laminating, exposure and development, and etching. A spacing between the conductors 26 with a relatively high distribution density may be enlarged by using the RDL technology, and the conductor 26 corresponding to the heat dissipation region A is led out to the edge region B, to facilitate soldering of the lead terminal 25 in the edge region B subsequently, and dispose a second thermally conductive component 3 in the heat dissipation region A. The second line layer 23 formed by using the RDL technology is relatively thin. Compared with formation of the second line layer by using a conventional line forming method, this helps reduce a total thickness of the circuit substrate 2.

In this embodiment, the first through hole 221 and the second through hole 222 may be formed by using laser drilling or mechanical drilling, the conductor 26 may be formed by using electroplating copper or filling and curing conductive paste, and the heat conductor 28 may be formed by using electroplating copper, filling and curing conductive paste, or filling and curing another thermally conductive material.

S15: As shown in FIG. 9F, dispose the lead terminal 25 on the edge region B of the second line layer 23, so that the lead terminal 25 is electrically connected to the second line layer 23, to form the circuit substrate 2 on the surface of the first thermally conductive component 1.

The lead terminal 25 may be connected to the connection pad 232 by attaching an anisotropic conductive adhesive or soldering.

After the circuit substrate 2 is formed on the surface of the first thermally conductive component 1, the method for preparing a packaging module 100 further includes the following step:
disposing the second thermally conductive component 3 on the heat dissipation region A of the second line layer 23.

The second thermally conductive component 3 may be connected to the second line layer 23 through a connection layer 4. The connection layer 4 may be a thermally conductive adhesive layer (for example, thermally conductive silica gel) or a soldering layer. In this embodiment, the second thermally conductive component 3 is attached to a surface of the second line layer 23 by using the thermally conductive silica gel. This helps simplify a process, reduce a quantity of soldering times, improve forming efficiency, reduce costs, and improve stability of the packaging module 100.

By directly forming the circuit substrate 2 on the surface of the first thermally conductive component 1 and mounting the second thermally conductive component 3, an entirety including the circuit substrate 2, the first thermally conductive component 1, and the second thermally conductive component 3 may be formed in one step. The forming method is simple, easy to implement, and facilitates mass production. In addition, in an entire process, the quantity of soldering times is small, forming efficiency is high, and reliability of the packaging module 100 is relatively high.

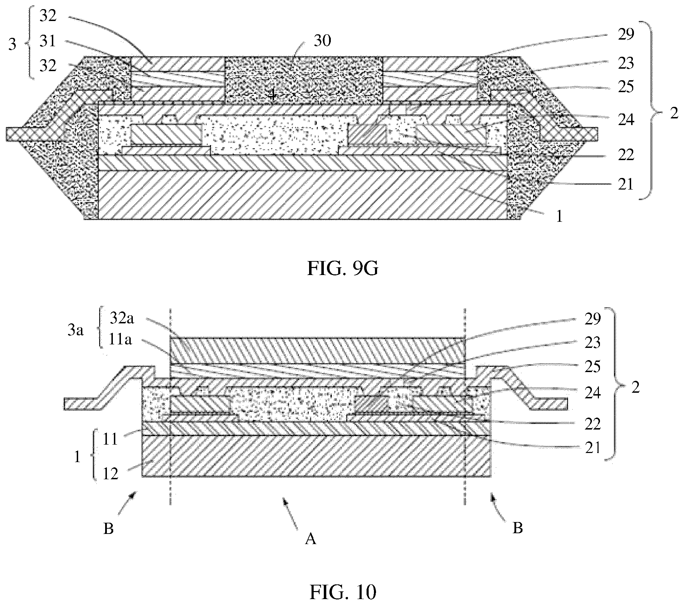

As shown in FIG. 9G, before the first heat dissipation apparatus 10 and the second heat dissipation apparatus 20 are disposed, the method for preparing a packaging module 100 further includes the following step:
disposing a second packaging layer 30 configured to package the first thermally conductive component 1, the circuit substrate 2, and the second thermally conductive component 3. A surface, away from the circuit substrate 2, of the first thermally conductive component 1 and a surface, away from the circuit substrate 2, of the second thermally conductive component 3 are exposed from the second packaging layer 30, and the lead terminal 25 extends out of the second packaging layer 30.

Stability of the packaging module 100 can be improved by adding the second packaging layer 30.

With reference to FIG. 2 for step S2 and step S3, the first heat dissipation apparatus 10 and the second heat dissipation apparatus 20 may be respectively connected to the first thermally conductive component 1 and the second thermally conductive component 3 through a thermally conductive layer or a soldering layer.

According to the method for preparing a packaging module 100 provided in this application, the circuit substrate 2 is directly formed on the surface of the first thermally conductive component 1, and the circuit substrate 2 includes the first line layer 21 and the second line layer 23. The first line layer 21 facilitates mounting of the first heat dissipation apparatus 10 on the back surface of the first electronic component 24. The second line layer 23 is formed by using the redistribution layer technology, to help lead out pins of high density of the first electronic component 24 from the front surface of the first electronic component 24 to the edge region B of the second line layer 23, and the heat dissipation region A of the second line layer 23 is reserved to mount the second thermally conductive component 3, to mount the second heat dissipation apparatus 20 on the front surface of the first electronic component 24, so that the packaging module 100 implements double-sided heat dissipation without affecting the mounting of the lead terminal 25. This effectively improves heat dissipation effect. In addition, the second line layer 23 formed by using the redistribution layer technology is relatively thin. Compared with formation of the second line layer by using a conventional line forming method, this helps reduce a total thickness of the circuit substrate 2, thereby facilitating design of thinness and a small size of the packaging module 100. The method for preparing a packaging module 100 in this application has a simple process, is relatively easy to implement, has low costs, and facilitates mass production. In addition, in the entire process, the quantity of soldering times is small, and forming efficiency is high, improving the reliability of the packaging module 100.

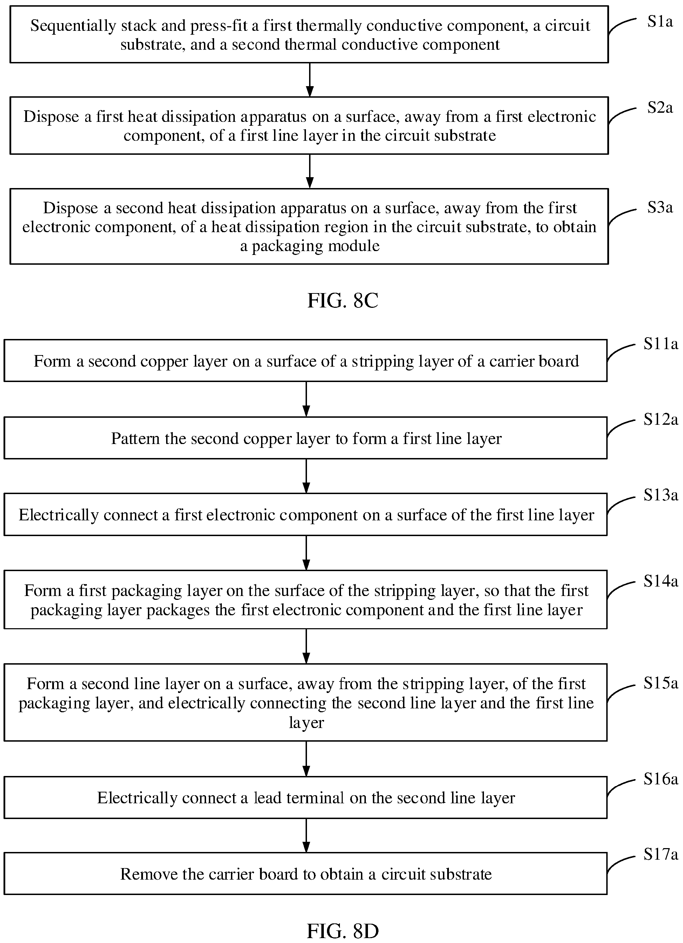

Refer to FIG. 8C. Another embodiment of this application further provides a method for preparing a packaging module 200. A difference between the method for preparing a packaging module 200 in this embodiment and the method for preparing a packaging module 100 in the foregoing embodiment lies in that: A first thermally conductive component 1 is disposed between the first line layer 21 and the first heat dissipation apparatus 10, a second thermally conductive component 3a is disposed between the heat dissipation region A and the second heat dissipation apparatus 20, and a method for preparing the circuit substrate 2 and a manner for connecting the circuit substrate 2 to the first thermally conductive component 1 and the second thermally conductive component 3a are different. The method for preparing a packaging module 200 in this embodiment includes the following steps.

S1a: With reference to FIG. 10, sequentially stack and press-fit the first thermally conductive component 1, the circuit substrate 2, and the second thermally conductive component 3a.

It may be understood that, after the first thermally conductive component 1 and the second thermally conductive component 3a are press-fitted, a second metal layer 12 on the first thermally conductive component 1 and a third metal layer 32a on the second thermally conductive component 3a may be electroplated and thickened according to an actual requirement.

S2a: With reference to FIG. 7, dispose the first heat dissipation apparatus 10 on a surface, away from the circuit substrate 2, of the first thermally conductive component 1.

S3a: With reference to FIG. 7, dispose the second heat dissipation apparatus 20 on a surface, away from the circuit substrate 2, of the second thermally conductive component 3a, to obtain the packaging module 200.

For mounting of the first heat dissipation apparatus 10 and the second heat dissipation apparatus 20, refer to the method in the foregoing embodiments.

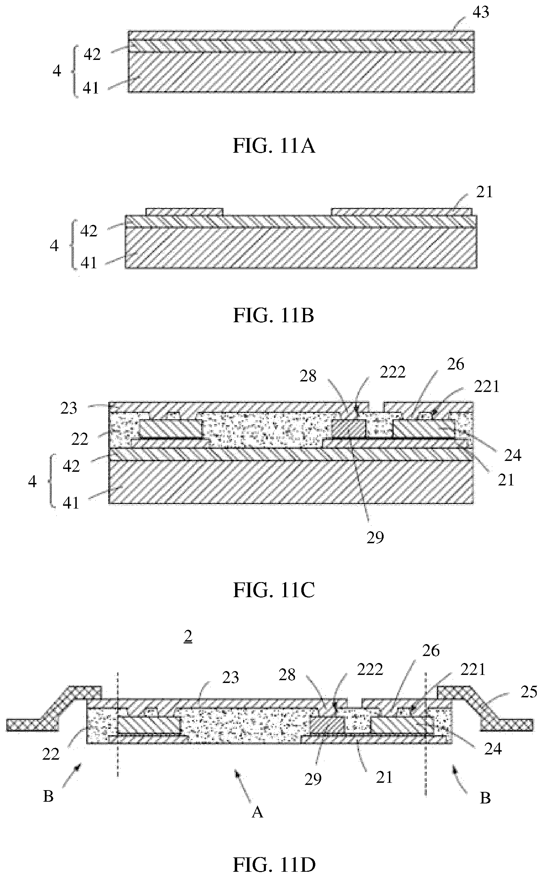

For step S1a, refer to FIG. 8D. With reference to FIG. 11A to FIG. 11D, a specific manner for forming the circuit substrate 2 includes the following steps.

S11a: As shown in FIG. 11A, form a second copper layer 43 on a surface of a stripping layer 42 of a carrier board 40.

The carrier board 40 includes a substrate layer 41 and the stripping layer 42 that is located on at least one surface of the substrate layer 41, and the second copper layer 43 is formed on a surface, away from the substrate layer 41, of the stripping layer 42.

The substrate layer 41 is a carrying board that forms the circuit substrate 2, and a material of the substrate layer 41 is not limited. The stripping layer 42 temporarily bonds the substrate layer 41 and the second copper layer 43. The stripping layer 42 is an insulation material, and the stripping layer 42 may be an adhesive that can be easily separated or removed during subsequent processing.

Step S12a: As shown in FIG. 11B, pattern the second copper layer 43 to form the first line layer 21.

Specifically, the first line layer 21 is formed by laminating on a surface of the second copper layer 43, and sequentially performing exposure and development, and etching.

Step S13a: As shown in FIG. 11C, electrically connect a first electronic component 24 on a surface of the first line layer 21.

For a method for mounting the first electronic component 24, refer to the foregoing method.

Step S14a: As shown in FIG. 11C, form a first packaging layer 22 on the surface of the stripping layer 42, so that the first packaging layer 22 packages the first electronic component 24 and the first line layer 21.

Step S15a: As shown in FIG. 11C, form a second line layer 23 on a surface, away from the stripping layer 42, of the first packaging layer 22, and electrically connect the second line layer 23 and the first line layer 21.

For a method for forming the second line layer 23, refer to the foregoing method.

Step S 16a: As shown in FIG. 11D, electrically connect a lead terminal 25 on the second line layer 232.

Step S17a: As shown in FIG. 11D, remove the carrier board 40 to obtain the circuit substrate 2.

It may be understood that a third thermally conductive component 29 may be further disposed on the first line layer 21, and a second electronic component 27 may be disposed on the second line layer 23. For a specific method, refer to the foregoing embodiment.

Before the first heat dissipation apparatus 10 and the second heat dissipation apparatus 20 are disposed, the method for preparing a packaging module 200 further includes the following step:
disposing a second packaging layer 30 configured to package the first thermally conductive component 1, the circuit substrate 2, and the second thermally conductive component 3a, where a surface, away from the circuit substrate 2, of the first thermally conductive component 1 and a surface, away from the circuit substrate 2, of the second thermally conductive component 3a are exposed from the second packaging layer 30, and the lead terminal 25 extends out of the second packaging layer 30.

First, the circuit substrate 2 having the first line layer 21 and the second line layer 23 is prepared, and then the first thermally conductive component 1 and the second thermally conductive component 3a are press-fitted on surfaces of the first line layer 21 and the second line layer 23. The forming method is simple, a quantity of soldering times is further reduced, and forming efficiency and reliability of the packaging module 200 are improved. In addition, the circuit substrate 2 is separately formed. This further simplifies a forming process and reduces a forming difficulty of the packaging module 100. In addition, the circuit substrate 2 has relatively high universality, and efficiency of press-fitting with the second thermally conductive component 3a and the first thermally conductive component 1 is improved, further improving the forming efficiency of the packaging module 100 and increasing a product yield.

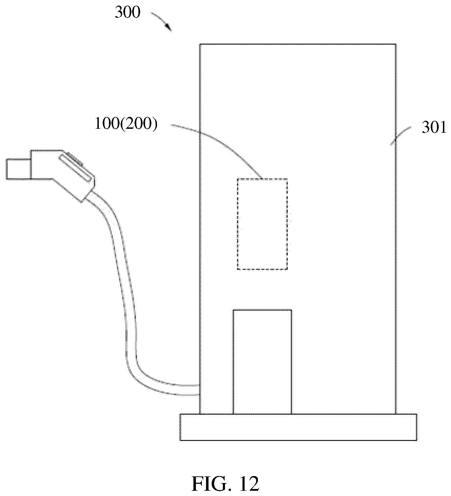

As shown in FIG. 12, this application further provides an electronic device 300. The electronic device 300 includes a housing 301 and the foregoing high-power packaging module 100 (or 200) located in the housing 301. The electronic device 300 may be an in-vehicle power supply, a photovoltaic inverter, a site energy, an industrial motor drive, or the like. In this embodiment, the electronic device 300 is a charging pile of an electric vehicle.

It should be noted that the foregoing descriptions are merely specific implementations of this application, but are not intended to limit the protection scope of this application. Any variation or replacement readily figured out by a person skilled in the art within the technical scope disclosed in this application shall fall within the protection scope of this application. When no conflict occurs, implementations of this application and the features in the implementations may be mutually combined. Therefore, the protection scope of this application shall be subject to the protection scope of the claims.

## Claims

1. A packaging module, comprising:
a circuit substrate, comprising a first line layer, a first packaging layer, and a second line layer that are sequentially stacked, wherein the first line layer is electrically connected to a first electronic component, the second line layer comprises a heat dissipation region and an edge region that is connected to the heat dissipation region, the first electronic component is further electrically connected to the heat dissipation region, the edge region is electrically connected to a lead terminal, and the first packaging layer packages the first electronic component and the first line layer;
a first heat dissipation apparatus, located on a surface, away from the first electronic component, of the first line layer; and
a second heat dissipation apparatus, located on a surface, away from the first electronic component, of the heat dissipation region.

2. The packaging module according to claim 1, wherein a first thermally conductive component is disposed between the first line layer and the first heat dissipation apparatus.

3. The packaging module according to claim 2, wherein a second thermally conductive component is disposed between the heat dissipation region and the second heat dissipation apparatus.

4. The packaging module according to claim 3, wherein the packaging module further comprises a second packaging layer, the second packaging layer packages the first thermally conductive component, the circuit substrate, and the second thermally conductive component, a surface, away from the circuit substrate, of the first thermally conductive component and a surface, away from the circuit substrate, of the second thermally conductive component are exposed from the second packaging layer, and the lead terminal extends out of the second packaging layer.

5. The packaging module according to claim 4, wherein the lead terminal extends out of a side wall of the second packaging layer.

6. The packaging module according to claim 1, wherein the second line layer comprises a conducting wire and a first metal layer, two ends of the conducting wire are respectively electrically connected to the first electronic component and the lead terminal, and the first metal layer is located in the heat dissipation region and connected to the second heat dissipation apparatus.

7. The packaging module according to claim 1, wherein a third thermally conductive component packaged in the first packaging layer is further disposed on the first line layer, and the third thermally conductive component is separately connected to the first line layer and the second line layer.

8. The packaging module according to claim 1, wherein the second line layer is further electrically connected to a second electronic component.

9. The packaging module according to claim 2, wherein the first thermally conductive component comprises a first insulative and thermally conductive layer and a second metal layer that are stacked, and the first insulative and thermally conductive layer is located between the first line layer and the second metal layer.

10. The packaging module according to claim 3, wherein the second thermally conductive component comprises a second insulative and thermally conductive layer and a third metal layer that are stacked, and the second insulative and thermally conductive layer is located between the second line layer and the third metal layer.

11. The packaging module according to claim 3, wherein the second thermally conductive component comprises a second insulative and thermally conductive layer and two third metal layers located on two opposite surfaces of the second insulative and thermally conductive layer, one of the third metal layers is connected to the second line layer through a connection layer, and the connection layer is made of a thermally conductive material.

12. A method for preparing a packaging module, comprising the following steps:
providing a circuit substrate, wherein the circuit substrate comprises a first line layer, a first packaging layer, and a second line layer that are sequentially stacked, the first line layer is electrically connected to a first electronic component, the second line layer comprises a heat dissipation region and an edge region that is connected to the heat dissipation region, the first electronic component is further electrically connected to the heat dissipation region, the edge region is electrically connected to a lead terminal, and the first packaging layer packages the first electronic component and the first line layer;
disposing a first heat dissipation apparatus on a surface, away from the first electronic component, of the first line layer; and
disposing a second heat dissipation apparatus on a surface, away from the first electronic component, of the heat dissipation region, to obtain the packaging module.

13. The method for preparing a packaging module according to claim 12, wherein a first thermally conductive component is disposed between the first line layer and the first heat dissipation apparatus, and a method for preparing the circuit substrate comprises the following steps:
forming the first line layer on a surface of the first thermally conductive component;
electrically connecting the first electronic component on a surface of the first line layer;
forming the first packaging layer on the surface of the first thermally conductive component, so that the first packaging layer packages the first electronic component and the first line layer;
forming the second line layer on a surface, away from the first thermally conductive component, of the first packaging layer, and electrically connecting the second line layer and the first electronic component; and
disposing the lead terminal on the edge region of the second line layer, so that the lead terminal is electrically connected to the second line layer, to form the circuit substrate on the surface of the first thermally conductive component.

14. The method for preparing a packaging module according to claim 13, wherein after the circuit substrate is formed on the surface of the first thermally conductive component, the method for preparing a packaging module further comprises the following step:
disposing a second thermally conductive component on the heat dissipation region of the second line layer.

15. The method for preparing a packaging module according to claim 12, wherein a first thermally conductive component is disposed between the first line layer and the first heat dissipation apparatus, and a second thermally conductive component is disposed between the heat dissipation region and the second heat dissipation apparatus, and after the circuit substrate is obtained, the method for preparing a packaging module further comprises the following step:
sequentially stacking and press-fitting the first thermally conductive component, the circuit substrate, and the second thermally conductive component.

16. The method for preparing a packaging module according to claim 15, wherein a method for preparing the circuit substrate comprises the following steps:
forming a second copper layer on a surface of a stripping layer of a carrier board;
patterning the second copper layer to form the first line layer;
electrically connecting the first electronic component on a surface of the first line layer;
forming the first packaging layer on the surface of the stripping layer, so that the first packaging layer packages the first electronic component and the first line layer;
forming the second line layer on a surface, away from the stripping layer, of the first packaging layer, and electrically connecting the second line layer and the first line layer;
electrically connecting the lead terminal on the second line layer; and
removing the carrier board to obtain the circuit substrate.

17. The method for preparing a packaging module according to claim 13 or 16, wherein before the forming the first packaging layer, the method for preparing the circuit substrate further comprises the following step:
disposing a third thermally conductive component on the first line layer, and connecting the third thermally conductive component to the first line layer.

18. The method for preparing a packaging module according to claim 13 or 16, wherein after the forming the second line layer, the method for preparing a packaging module further comprises the following step:
electrically connecting a second electronic component on the second line layer.

19. The method for preparing a packaging module according to claim 13 or 16, wherein the second line layer is formed by using a redistribution layer technology.

20. The method for preparing a packaging module according to claim 14 or 16, wherein before the first heat dissipation apparatus and the second heat dissipation apparatus are disposed, the method for preparing a packaging module further comprises the following step:
disposing a second packaging layer configured to package the first thermally conductive component, the circuit substrate, and the second thermally conductive component, wherein a surface, away from the circuit substrate, of the first thermally conductive component and a surface, away from the circuit substrate, of the second thermally conductive component are exposed from the second packaging layer, and the lead terminal extends out of the second packaging layer.

21. An electronic device, comprising a housing and the packaging module according to any one of claims 1 to 11 that is located in the housing.
